# EUROPEAN PATENT APPLICATION

(11) **EP 4 644 818 A1**
(43) Date of publication of application: **05.11.2025**
(21) Application number: 24770822.5
(22) Date of filing: 11.03.2024
(51) Int. Cl.: F28D 15/02

(54) **HEAT TRANSPORT DEVICE**

(30) Priority: 16.03.2023 JP 2023041492
(71) Applicant: FURUKAWA ELECTRIC CO., LTD., Tokyo 100-8322 (JP)
(72) Inventor: TAKADA, Saki, Tokyo 100-8322 (JP); NAKAMURA, Toshiaki, Tokyo 100-8322 (JP); UEKUBO, Masahiro, Tokyo 100-8322 (JP)
(74) Representative: Papula Oy
(86) International application number: PCT/JP2024/009225
(87) International publication number: WO 2024/190716

(57) **Abstract**

Provided is a heat transport device capable of operating satisfactorily even in a below-freezing environment. The heat transport device comprises one or more high-temperature side heat pipes filled with a high-temperature side working fluid, and one or more low-temperature side heat pipes filled with a low-temperature side working fluid, wherein: the high-temperature side working fluid is water; the low-temperature side working fluid is a mixed liquid consisting of water and a liquid having a melting point lower than the melting point of water; and the high-temperature side heat pipe and the low-temperature side heat pipe are in thermal contact at least at a portion thereof.

## Description

### TECHNICAL FIELD

The present disclosure relates to a heat transport device.

### BACKGROUND ART

Conventionally, heat transport devices including heat pipes are being used in various fields. The heat pipes constituting the heat transport device achieve cooling by conveying the heat generated from a heat source to another location.

Although heat pipes operate favorably under a room-temperature environment, it may not be possible to favorably operate as under a room-temperature environment when under a low-temperature environment, and may be completely unable to operate depending on the case.

To address such a problem, for example, Patent Document 1 describes a cooler equipped with a heat pipe that establishes water as the working fluid; a heat-absorbing block mounted to a heat absorption side of the heat pipe; fins mounted to a heat-radiating side of the heat pipe; and a hollow pipe mounted to the heat-absorbing block and the fins in parallel to the heat pipe, and in which an antifreeze solution is filled in an enclosed space inside.

However, with the cooler of Patent Document 1, since the temperature difference in the hollow pipe is large, there is room for improvement in the heat transport characteristic under environments below the freezing point.

### Citation List

### Patent Document

Patent Document 1: Japanese Unexamined Patent Application, Publication No. H11-183065

### DISCLOSURE OF THE INVENTION

### Problems to be Solved by the Invention

An object of the present disclose is to provide a heat transport device which can favorably operate even in an environment below the freezing point.

### Means for Solving the Problems

[1] A heat transport device includes: one or more of a high-temperature-side heat pipe in which a high-temperature-side working fluid is filled; and one or more of a low-temperature-side heat pipe in which a low-temperature-side working fluid is filled, in which the high-temperature-side working fluid is water, the low-temperature-side working fluid is a liquid mixture including water and a liquid having a melting point lower than the melting point of water, and the high-temperature-side heat pipe and the low-temperature-side heat pipe are at least partially in thermal contact.
[2] The heat transport device as described in [1] above further includes a heat conduction member that connects the one or more of the high-temperature-side heat pipe and the one or more of the low-temperature-side heat pipe, in which the high-temperature-side heat pipe and the low-temperature-side heat pipe are in thermal contact via the heat conduction member.
[3] In the heat transport device as described in [2] above, the heat conduction member connects a condensation section of the high-temperature-side heat pipe and a condensation section of the low-temperature-side heat pipe.
[4] In the heat transport device as described in any one of [1] to [3] above, the liquid is an alcohol, a ketone, an ether or a glycol.
[5] In the heat transport device as described in any one of [1] to [4] above, the liquid is a C6 or lower alcohol, a C6 or lower ketone, a C6 or lower ether, or a C6 or lower glycol.
[6] In the heat transport device as described in any one of [1] to [5] above, the liquid is acetone.
[7] In the heat transport device as described in any one of [1] to [6] above, a concentration of the liquid contained in the low-temperature-side working fluid is 1 wt% or more and 40 wt% or less.

### Effects of the Invention

According to the present disclosure, it is possible to provide a heat transport device which can favorably operate even in an environment below the freezing point.

### BRIEF DESCRIPTION OF THE DRAWINGS

FIG. 1 is a schematic drawing showing an example of a heat transport device according to an embodiment.
FIG. 2 is a cross-sectional view along the line A-A in FIG. 1.
FIG. 3 is a cross-sectional view showing another example in which a high-temperature-side heat pipe and a low-temperature-side heat pipe are in thermal contact.
FIG. 4 is a cross-sectional view showing another example in which a high-temperature-side heat pipe and a low-temperature-side heat pipe are in thermal contact.
FIG. 5 is a cross-sectional view showing another example in which a high-temperature-side heat pipe and a low-temperature-side heat pipe are in thermal contact.
FIG. 6 is a cross-sectional view showing another example in which a high-temperature-side heat pipe and a low-temperature-side heat pipe are in thermal contact.
FIG. 7 is a cross-sectional view showing another example in which a high-temperature-side heat pipe and a low-temperature-side heat pipe are in thermal contact.
FIG. 8 is a cross-sectional view showing another example in which a high-temperature-side heat pipe and a low-temperature-side heat pipe are in thermal contact.
FIG. 9 is a cross-sectional view showing another example in which a high-temperature-side heat pipe and a low-temperature-side heat pipe are in thermal contact.
FIG. 10 is a schematic drawing showing another example of a heat transport device according to an embodiment.
FIG. 11 is a schematic drawing showing another example of a heat transport device according to an embodiment.
FIG. 12 is a schematic drawing showing another example of a heat transport device according to an embodiment.
FIG. 13 is a schematic drawing showing another example of a heat transport device according to an embodiment.

### PREFERRED MODE FOR CARRYING OUT THE INVENTION

Hereinafter, the present invention will be described in detail based on an embodiment.

As a result of thorough investigation, the present inventors have found that, by providing a high-temperature-side heat pipe and a low-temperature-side heat pipe, and establishing the working fluid filled in each of the heat pipes as predetermined substances, it is possible for a heat transport device to favorably operate even under an environment below the freezing point, and based on such knowledge, arrived at completion of the present disclosure.

A heat transport device according to an embodiment includes one or more of a high-temperature-side heat pipe in which a high-temperature-side working fluid is filled, and one or more of a low-temperature-side heat pipe in which a low-temperature-side working fluid is filled, in which the high-temperature-side working fluid is water, the low-temperature-side working fluid is a liquid mixture including water and a liquid having a melting point lower than the melting point of water, and the high-temperature-side heat pipe and the low-temperature-side heat pipe are at least partially in thermal contact.

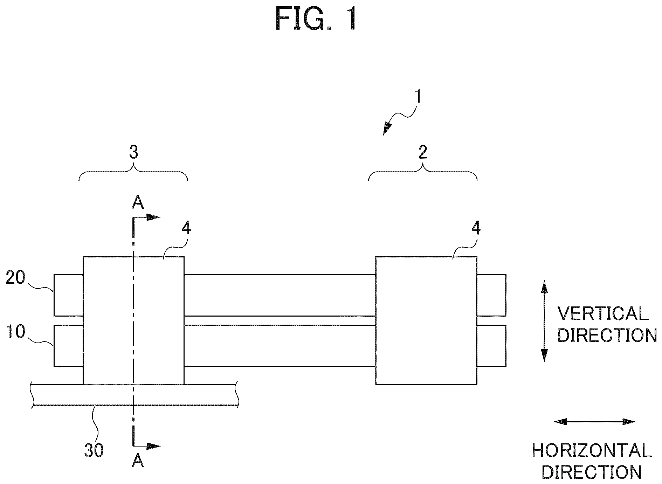

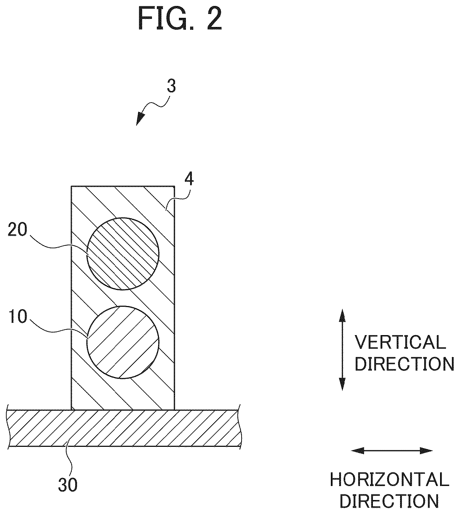

FIG. 1 is a schematic drawing showing an example of a heat transport device according to an embodiment. FIG. 2 is a cross-sectional view along the line A-A in FIG. 1, and is an example in which a low-temperature-side heat pipe 20 and a high-temperature-side heat pipe 10 are in thermal contact. As shown in FIGS. 1 and 2, the heat transport device 1 according to the embodiment includes one or more of the high-temperature-side heat pipe 10 and one or more of the low-temperature-side heat pipe 20. Herein, an example is shown in which there is one of the high-temperature-side heat pipes 10, there is one of the low-temperature-side heat pipes 20, and the high-temperature-side heat pipe 10 and the low-temperature-side heat pipe 20, which are arranged in parallel to one another, are each in thermal contact via heat conduction members 4 at an evaporation section 2 and a condensation section 3 of the heat transport device 1.

A high-temperature-side working fluid (not shown) is filled inside of the high-temperature-side heat pipe 10 constituting the heat transport device 1. In addition, inside of the high-temperature-side heat pipe 10, a functional structure (not shown) may be provided such as a wick that improves the heat transport characteristic by exhibiting the capillary phenomenon with respect to the high-temperature-side working fluid.

The transverse sectional shape of the high-temperature-side heat pipe 10 is not particularly limited, and may be circular as shown in FIG. 2, for example, or may be a flat shape. In addition, the inner profile dimension of the high-temperature-side heat pipe 10 (inside diameter, width of high-temperature-side heat pipe 10) is on the order of 4 to 8 mm, for example.

The high-temperature-side working fluid filled inside of the high-temperature-side heat pipe 10 is water. Regarding the water, in the case of being tap water which abundantly contains contaminants, since there is a possibility of gas generating inside the high-temperature-side heat pipe 10 as the heat transport device 1 is repeatedly used, and inducing a performance decline in the high-temperature-side heat pipe 10, it is preferably pure water.

A low-temperature-side working fluid (not shown) is filled inside of the low-temperature-side heat pipe 20 constituting the heat transport device 1. In addition, inside of the low-temperature-side heat pipe 20, a functional structure (not shown) such as a wick improving the heat transport characteristic by exhibiting the capillary phenomenon with respect to the low-temperature-side working fluid may be provided.

The transverse sectional shape of the low-temperature-side heat pipe 20 is not particularly limited, and may be circular as shown in FIG. 2, for example, or may be a flat shape. In addition, the inner profile dimension of the low-temperature-side heat pipe 20 (inside diameter, width of low-temperature-side heat pipe 20) is on the order of 4 to 8 mm, for example.

The low-temperature-side working fluid filled inside the low-temperature-side heat pipe 20 is a liquid mixture, which is constituted from water and a liquid having a melting point lower than the melting point of water. The above-mentioned liquid constituting the low-temperature-side working fluid indicates a component other than water in the low-temperature-side working fluid (liquid mixture) inside of the low-temperature-side heat pipe 20, and is liquid form at the moment filled to the low-temperature-side heat pipe 20. The low-temperature-side working fluid within the low-temperature-side heat pipe 20 differs from the high-temperature side working fluid within the high-temperature-side heat pipe 10.

Regarding the water included in the low-temperature-side working fluid, in the case of being tap water which abundantly contains contaminants, since there is a possibility of gas generating inside the low-temperature-side heat pipe 20 as the heat transport device 1 is repeatedly used, and inducing a performance decline in the low-temperature-side heat pipe 20, it is preferably pure water.

In the heat transport device 1, the high-temperature-side heat pipe 10 and the low-temperature-side heat pipe 20 are not provided independently, but rather are at least partially in thermal contact. Regarding the thermal contact between the high-temperature-side heat pipe 10 and the low-temperature-side heat pipe 20, it is sufficient if both the high-temperature-side heat pipe 10 and the low temperature-side heat pipe 20 are in direct contact. In addition, as shown in FIG. 1, it is sufficient if a heat conduction member 4 or a block (not shown) that connects one or more of the high-temperature-side heat pipes 10 and one or more of the low-temperature-side heat pipes 20 is further included, and the high-temperature-side heat pipe 10 and the low-temperature heat pipe 20 are in thermal contact via the heat conduction member 4 or the block.

The evaporation section 2 of the heat transport device 1 is a portion receiving the heat generated from a heat source (not shown), and is configured from an evaporation section of the high-temperature-side heat pipe 10 and an evaporation section of the low-temperature-side heat pipe 20. The condensation section 3 of the heat transport device 1 is a portion emitting the heat from the heat source, and is configured from a condensation section of the high-temperature-side heat pipe 10 and a condensation section of the low-temperature-side heat pipe 20. The heat generated by the heat source (not shown) is transmitted from the evaporation section 2 of the heat transport device 1 to the condensation section 3 via the high-temperature-side heat pipe 10 and the low-temperature-side heat pipe 20, and is emitted from a cooling surface 30.

The high-temperature-side heat pipe 10 favorably operates on the high-temperature side compared to the low-temperature-side heat pipe 20, and the low-temperature-side heat pipe 20 favorably operates on the low-temperature side compared to the high-temperature-side heat pipe 10. In addition, the water within the high-temperature-side heat pipe 10 is a working fluid having a large amount of heat transport; therefore, the heat transport characteristic of the heat transport device 1 at high temperature is superior.

In this way, with the heat transport device 1 established by combining the high-temperature-side heat pipe 10 that uses the high-temperature-side working fluid which is water, and the low-temperature-side heat pipe 20 that uses the low-temperature-side working fluid which is a mixed aqueous solution of water and a liquid having a melting point lower than that of water, the low-temperature-side heat pipe 20 equipped with the low-temperature-side working fluid containing a liquid having a lower melting point than water mainly operates in a low-temperature environment such as below the freezing point, and the high-temperature-side heat pipe 10 equipped with the high-temperature-side working fluid which is water mainly operates in a high-temperature environment higher than the freezing point. For this reason, the heat transport device 1 can favorably operate even in an environment below the freezing point, and can favorably operate in a broader temperature region than conventionally, particularly in a broad temperature region whose low temperature side is wide. Such a heat transport device 1 can favorably operate within a range of -50°C to 70°C, for example.

In addition, compared to the temperature difference inside of a pipe filled with a predetermined liquid in a hollow pipe, the temperature difference inside of the high-temperature-side heat pipe 10 and the low-temperature-side heat pipe 20 having the function of heat pipe is small, and thus the thermal responsiveness of the high-temperature-side heat pipe 10 and the low-temperature-side heat pipe 20 is superior compared to the above-mentioned pipe.

In addition, compared to a heat pipe establishing a fluorine-based solvent, alcohol or the like as the working fluid, the low-temperature-side heat pipe 20 possessing the low-temperature-side working fluid containing a liquid having a lower melting point than water has a large temperature difference within the pipe, and can continually supply heat for melting the high-temperature-side working fluid frozen at the condensation section of the high-temperature-side heat pipe 10 to at least the condensation section of the high-temperature-side heat pipe 10 via a thermal contact portion. As a result, the high-temperature-side heat pipe 10 which has not operated below the freezing point also comes to be operated.

Furthermore, even at a temperature at which the high-temperature-side heat pipe 10 alone would freeze, by including the low-temperature-side heat pipe 20, the high-temperature-side heat pipe 10 can continuously operate, and the operable temperature range of the high-temperature-side heat pipe 10 is expanded. In addition, due to the temperature difference within the pipe of the low-temperature-side heat pipe 20 being large, the operating temperature rises relative to the ambient temperature and thus the amount of heat transport improves compared to a heat pipe establishing a fluorine-based solvent, alcohol or the like as the working fluid.

In addition, the liquid having a melting point lower than water in the low-temperature-side working fluid is preferably an alcohol, a ketone, an ether or a glycol, is more preferably a C6 or lower alcohol, a C6 or lower ketone, a C6 or lower ether, or a C6 or lower glycol, and even more preferably a C4 or lower alcohol, a C4 or lower ketone, a C4 or lower ether, or a C4 or lower glycol. Due to such a liquid being easily soluble in water, it is possible to improve the heat transport characteristic and operation reliability of the low-temperature-side heat pipe 20 below the freezing point. Among the above-mentioned liquids, it is preferably an alcohol, more preferably an ether or a glycol, and most preferably a ketone. Among ketones, acetone is preferable. The above-mentioned liquids are not necessarily soluble, and may be a combination with an insoluble substance and water.

In addition, the concentration of the liquid having a melting point lower than water contained in the low-temperature-side working fluid is preferably 1 wt% or higher and 40 wt% or lower. More specifically, in the case of emphasizing the heat transport characteristic of the low-temperature-side heat pipe 20, the concentration of the above-mentioned liquid in the low-temperature-side working fluid is preferably lower, for example, is preferably 1 wt% or higher and 10 wt% or lower. In addition, in the case of emphasizing the operation reliability of the low-temperature-side heat pipe 20 in environment below the freezing point, the concentration of the above-mentioned liquid in the low-temperature-side working fluid is preferably higher, for example, is preferably 30 wt% or higher and 40 wt% or lower.

If the concentration of the above-mentioned liquid is less than 1 wt%, there is no longer an advantageous difference compared to the case of using a plurality of high-temperature-side heat pipes 10, and it is not easy to continuously supply heat for melting the frozen high-temperature-side working fluid in the condensation section of the high-temperature-side heat pipe 10. In addition, when the concentration of the above-mentioned liquid exceeds 40 wt%, the temperature difference within the low-temperature-side heat pipe 20 is excessively large, and there is too much difference in thermal resistance from the high-temperature-side heat pipe 10; therefore, heat does not enter the low-temperature-side heat pipe 20, and an improvement in the amount of heat transport as a heat transport device in combination with the high-temperature-side heat pipe 10 is not easy.

In addition, although FIGS. 1 and 2 show examples in which the high-temperature-side heat pipe 10 and the low-temperature-side heat pipe 20 are each in thermal contact at the evaporation section 2 and the condensation section 3, from the viewpoint of operating the high-temperature-side heat pipe 10 equipped with the high-temperature-side working fluid even in an environment below the freezing point, it is preferable for the heat conduction member 4 to connect the condensation section of the high-temperature-side heat pipe 10 and the condensation section of the low-temperature-side heat pipe 20, as in the configuration shown on the left side of FIG. 1. With such a configuration, the heat conduction member 4 connects the condensation section of at least one high-temperature-side heat pipe 10 and the condensation section of at least one low-temperature-side heat pipe 20.

The heat conduction member 4 covers the surface of the at least one high-temperature-side heat pipe 10, along the extending direction of the high-temperature-side heat pipe 10. In addition, the heat conduction member 4 covers the surface of the at least one low-temperature-side heat pipe 20, along the extending direction of the low-temperature-side heat pipe 20.

With such a configuration, the high-temperature-side heat pipe 10 and the low-temperature-side heat pipe 20 are in thermal contact at the condensation section 3 side of the heat transport device 1. When the high-temperature-side heat pipe 10 and the low-temperature-side heat pipe 20 are in thermal contact at least at part of the condensation section 3, heat is transmitted from the condensation section of the low-temperature-side heat pipe 20 to the condensation section of the high-temperature-side heat pipe 10 below the freezing point. For this reason, it is possible to operate the high-temperature-side heat pipe 10 even if below the freezing point.

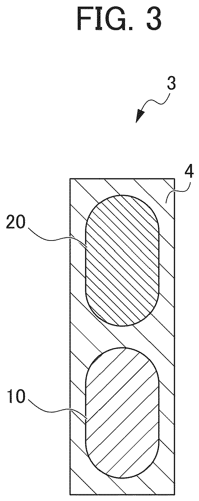

As an example in which the high-temperature-side heat pipe 10 and the low-temperature-side heat pipe 20 are in thermal contact, FIG. 2 shows a configuration in which the transverse sectional shapes of the high-temperature-side heat pipe 10 and the low-temperature-side heat pipe 20 are circular, the heat conduction member 4 is an integrated configuration, and the high-temperature-side heat pipe 10 and the low-temperature-side heat pipe 20 provided inside of the heat conduction member 4 are not in contact, and are independent. However, the configurations shown in FIGS. 3 to 9 are also suitable.

FIG. 3 shows a configuration in which the transverse sectional shapes of the high-temperature-side heat pipe 10 and the low-temperature-side heat pipe 20 are flat shapes, the heat conduction member 4 is an integrated configuration, and the high-temperature-side heat pipe 10 and the low-temperature-side heat pipe 20 provided inside of the heat conduction member 4 are independent. With such a configuration, the high-temperature-side heat pipe 10 and the low-temperature-side heat pipe 20 are in thermal contact via the heat conduction member 4.

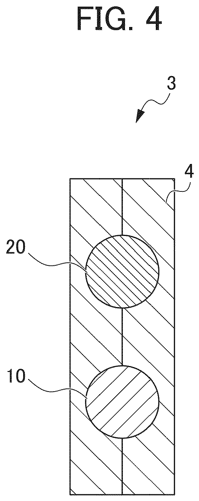

FIG. 4 shows a configuration in which the transverse sectional shapes of the high-temperature-side heat pipe 10 and the low-temperature-side heat pipe 20 are circular, the heat conduction member 4 is a half-split configuration, and the high-temperature-side heat pipe 10 and the low-temperature-side heat pipe 20 provided inside of the heat conduction member 4 are independent. With such a configuration, the high-temperature-side heat pipe 10 and the low-temperature-side heat pipe 20 are in thermal contact via the heat conduction member 4.

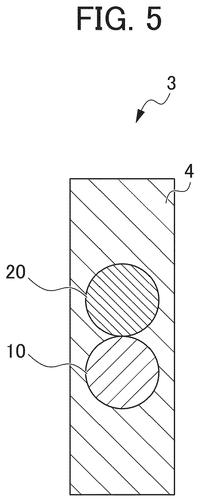

FIG. 5 shows a configuration in which the transverse sectional shapes of the high-temperature-side heat pipe 10 and the low-temperature-side heat pipe 20 are circular, the heat conduction member 4 is an integrated configuration, and the high-temperature-side heat pipe 10 and the low-temperature-side heat pipe 20 provided inside of the heat conduction member 4 are in line contact. With such a configuration, the high-temperature-side heat pipe 10 and the low-temperature-side heat pipe 20 are linearly in direct contact, and are in thermal contact via the heat conduction member 4.

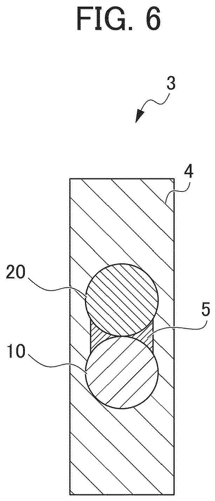

FIG. 6 shows a configuration in which the transverse sectional shapes of the high-temperature-side heat pipe 10 and the low-temperature-side heat pipe 20 are circular, the heat conduction member 4 is an integrated configuration, the high-temperature-side heat pipe 10 and the low-temperature-side heat pipe 20 provided inside of the heat conduction member 4 are in line contact, and a heat conduction material 5 is filled in the vicinity of the line contact. With such a configuration, the high-temperature-side heat pipe 10 and the low-temperature-side heat pipe 20 are linearly in direct contact, and are in thermal contact via the heat conduction member 4 and the heat conduction material 5.

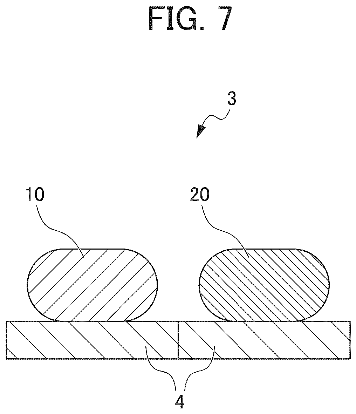

FIG. 7 shows a configuration in which the transverse sectional shapes of the high-temperature-side heat pipe 10 and the low-temperature-side heat pipe 20 are flat shapes, and the plate-shaped heat conduction member 4 supporting a flat portion of the high-temperature-side heat pipe 10 and the plate-shaped heat conduction member 4 supporting a flat portion of the low-temperature-side heat pipe 20 are in contact. With such a configuration, the high-temperature-side heat pipe 10 and the low-temperature-side heat pipe 20 are in thermal contact via the heat conduction members 4.

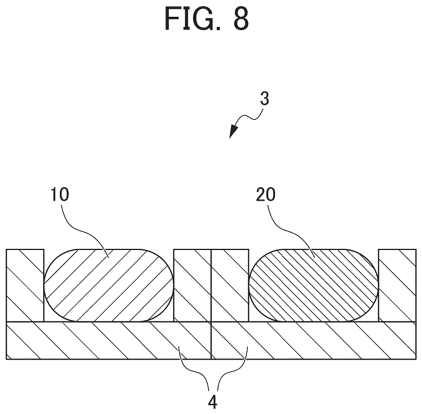

FIG. 8 shows a configuration in which the transverse sectional shapes of the high-temperature-side heat pipe 10 and the low-temperature-side heat pipe 20 are flat shapes, and the heat conduction member 4 supporting the flat portion of the high-temperature-side heat pipe 10 while covering a part of the high-temperature-side heat pipe 10 (for example, U-shaped heat conduction member 4) and the heat conduction member 4 supporting the flat portion of the low-temperature-side heat pipe 20 while covering a part of the low-temperature-side heat pipe 20 are in contact. With such a configuration, the high-temperature-side heat pipe 10 and the low-temperature-side heat pipe 20 are in thermal contact via the heat conduction members 4.

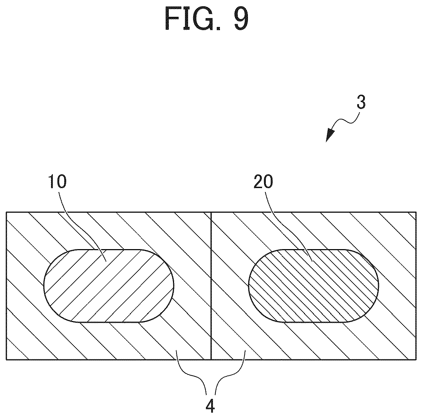

FIG. 9 shows a configuration in which the transverse sectional shapes of the high-temperature-side heat pipe 10 and the low-temperature-side heat pipe 20 are flat shapes, and the heat conduction member 4 penetrated by the high-temperature-side heat pipe 10 and the heat conduction member 4 penetrated by the low-temperature-side heat pipe 20 are in contact. With such a configuration, the high-temperature-side heat pipe 10 and the low-temperature-side heat pipe 20 are in thermal contact via the heat conduction members 4.

For the configuration shown above, the transverse sectional shapes of the high-temperature-side heat pipe 10 and the low-temperature-side heat pipe 20, the configuration of the heat conduction members 4, the presence/absence of filling of the heat conduction material 5, etc. may be modified where appropriate. For example, the high-temperature-side heat pipe 10 and the low-temperature-side heat pipe 20 are not necessarily cylindrical, and may be square shapes, the shapes may differ and the cross-sectional areas may greatly differ according to location. In addition, the high-temperature-side heat pipe 10 and the low-temperature-side heat pipe 20 may not necessarily be integral part, and may be obtained by assembling metal parts. In addition, it is not necessary for the evaporation section and the condensation section to be one per location, and may be several per location, and may be positioned anywhere.

In the above-mentioned way, the high-temperature-side heat pipe 10 and the low-temperature-side heat pipe 20 being in thermal contact may be the high-temperature-side heat pipe 10 and the low-temperature-side heat pipe 20 being in direct contact, the high-temperature-side heat pipe 10 and the low-temperature-side heat pipe 20 being in contact via the heat conduction member 4, or the high-temperature-side heat pipe 10 and the low-temperature-side heat pipe 20 being in contact via the heat conduction material 5. In addition, the heat conduction member 4 and the heat conduction material 5 may be used in conjunction.

For the coating of the heat conduction member 4 to the surface of the high-temperature-side heat pipe 10 and the coating of the heat conduction member 4 to the surface of the low-temperature-side heat pipe 20, from the viewpoint of favorably conducting heat between the high-temperature-side heat pipe 10 and the low-temperature-side heat pipe 20, the coating ratio of the heat conduction member 4 relative to the whole circumference of the respective pipes of the high-temperature-side heat pipe 10 and the low-temperature-side heat pipe 20 is preferably 10% or more, and more preferably 100% as in FIG. 2, etc. In addition, the coating length of the heat conduction member 4 along the extending direction of each pipe is preferably 5 mm or more, for example. In addition, if the coating area of the heat conduction member 4 relative to each pipe is 200 mm² or more, for example, heat will favorably conduct between the high-temperature-side heat pipe 10 and the low-temperature-side heat pipe 20. The coating ratio, etc. of the heat conduction material 5 are similar to the above-mentioned heat conduction member 4.

The heat conduction member 4 is preferably a metal member (metal block) constituted from a copper-based material such as copper or a copper alloy, an aluminum-based material such as aluminum or an aluminum alloy, or the like. If the heat conduction member 4 is a copper-based material, it is possible to further improve the heat transport characteristic of the heat transport device 1. If the heat conduction member 4 is an aluminum-based material, it is possible to reduce the weight of the heat transport device 1, while maintaining the favorable heat transport characteristic of the heat transport device 1. In addition, such a heat conduction member 4 may also serve a role of positioning the high-temperature-side heat pipe 10 and the low-temperature-side heat pipe 20.

The heat conduction material 5 is preferably a solder or grease, and is more preferably a solder.

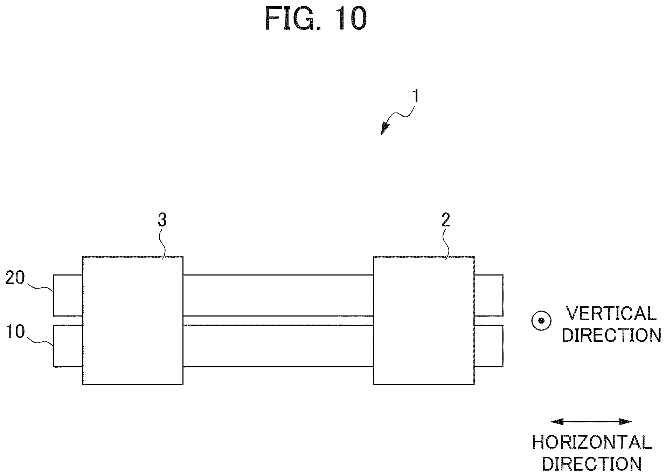

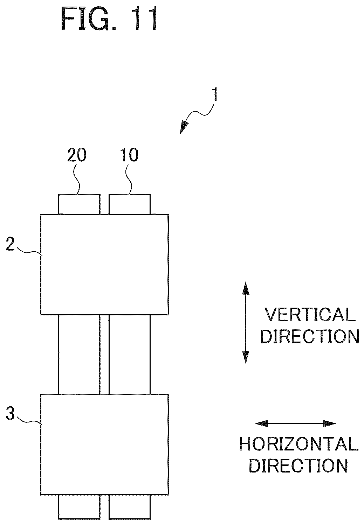

In addition, from the viewpoint of improving the heat transport characteristic of the heat transport device 1, the arrangement of the high-temperature-side heat pipe 10 and the low-temperature-side heat pipe 20 is preferably any of the following. More specifically, it is preferable for the high-temperature-side heat pipe 10 and the low-temperature-side heat pipe 20 to extend in a horizontal direction, and be arranged in parallel in the vertical direction as shown in FIG. 1, for the high-temperature-side heat pipe 10 and the low-temperature-side heat pipe 20 to extend in a horizontal direction, and be arranged in parallel in a horizontal direction as shown in FIG. 10, or for the high-temperature-side heat pipe 10 and the low-temperature-side heat pipe 20 to extend in the vertical direction, and be arranged in parallel in a horizontal direction as shown in FIG. 11.

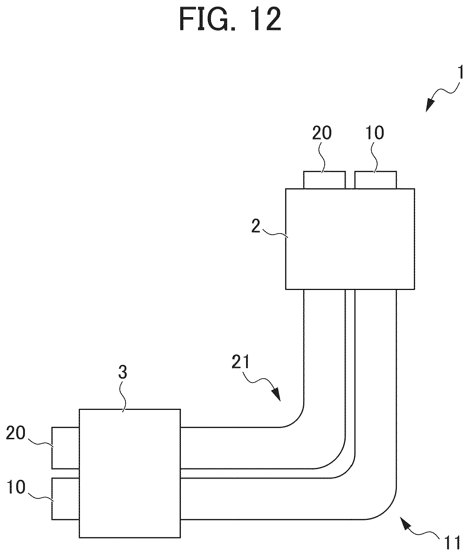

In addition, such a plurality of arrangements may be connected to each other as shown in FIG. 12. In this case, as shown in FIG. 12, a corner 11 of a connection portion of the high-temperature-side heat pipe 10 is preferably a rounded shape. Similarly, a corner 21 of a connection portion of the low-temperature-side heat pipe 20 is preferably a rounded shape. If the corners 11 and 21 provided between the evaporation section 2 and the condensation section 3 of the heat transport device 1 are rounded shapes, the high-temperature-side working fluid within the high-temperature-side heat pipe 10 can favorably flow in the corner 11, and the low-temperature-side working fluid within the low-temperature-side heat pipe 20 can favorably flow in the corner 21. For this reason, it is possible to sufficiently retain the favorable heat transport characteristic of the heat transport device 1. It should be noted that FIG. 12 shows an example in which two arrangement are connected at right angles via the corners 11 and 21; however, the connection angle of the two arrangements is not particularly limited, and is not necessarily a right angle.

In addition, in the case of the high-temperature-side heat pipe 10 and the low-temperature-side heat pipe 20 being stacked vertically, with the viewpoint of favorably operating the high-temperature-side heat pipe 10 using the temperature difference of the low-temperature-side heat pipe 20, it is preferable for the low-temperature-side heat pipe 20 to be closer to the cooling surface 30 than the high-temperature-side heat pipe 10. In other words, the heat pipe closer to the cooling source is preferably the low-temperature-side heat pipe 20. In addition, with the viewpoint of the heat transport device 1 retaining favorable thermal performance even in a high-temperature environment, it is preferable for the high-temperature-side heat pipe 10 to be closer to the cooling surface 30 and closer to the heat source than the low-temperature-side heat pipe 20, as shown in FIG. 1. Under a high-temperature environment, the thermal resistance of the high-temperature-side heat pipe 10 becomes higher compared to the low-temperature-side heat pipe 20. For this reason, by more efficiently cooling the high-temperature-side heat pipe 10 by an arrangement such as that of FIG. 1, it is possible to favorably operate the high-temperature-side heat pipe 10.

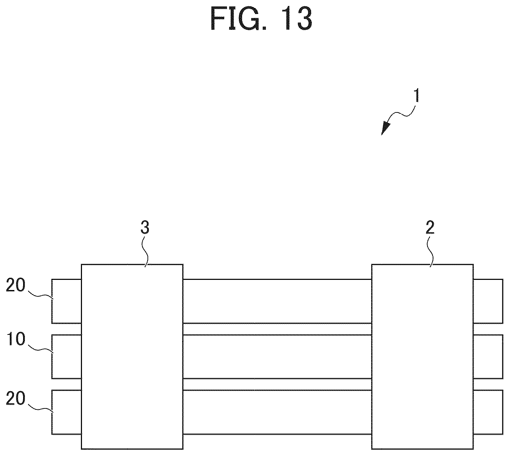

In addition, in the case of the heat transport device 1 including a plurality of the low-temperature-side heat pipes 20, from the viewpoint of efficiently operating the high-temperature-side heat pipe 10 at low temperatures, it is preferable to arrange in parallel so as to sandwich the high-temperature-side heat pipe 10 with two of the low-temperature-side heat pipes 20, as shown in FIG. 13.

In addition, in the case of requiring the heat transport device 1 to operate in a top heat orientation (orientation in which heat source is up and cooling surface is down), it is desired for a sintered body to be filled inside of each of the high-temperature-side heat pipe 10 and the low-temperature-side heat pipe 20 along the entire length of the pipes 10 and 20.

According to the embodiment described above, by including the high-temperature-side heat pipe and the low-temperature-side heat pipe, and establishing the working fluid filled into each of the heat pipes as predetermined substances, the heat transport device can favorably operate not only in a room-temperature environment, but even in an environment below the freezing point.

Although an embodiment has been described above, the present invention is not to be limited to the above-described embodiment, and can be modified in various ways within the scope of the present disclosure, encompassing all aspects included in the gist and scope of the claims of the present disclosure.

### EXPLANATION OF REFERENCE NUMERALS

1 heat transport device
2 evaporation section
3 condensation section
4 heat conduction member
5 heat conduction material
10 high-temperature-side heat pipe
11 corner of high-temperature-side heat pipe
20 low-temperature-side heat pipe
21 corner of low-temperature-side heat pipe
30 cooling surface

## Claims

1. A heat transport device comprising:
one or more of a high-temperature-side heat pipe in which a high-temperature-side working fluid is filled; and
one or more of a low-temperature-side heat pipe in which a low-temperature-side working fluid is filled, wherein
the high-temperature-side working fluid is water,
the low-temperature-side working fluid is a liquid mixture including water and a liquid having a melting point lower than the melting point of water, and
the high-temperature-side heat pipe and the low-temperature-side heat pipe are at least partially in thermal contact.

2. The heat transport device according to claim 1, further comprising a heat conduction member that connects the one or more of the high-temperature-side heat pipe and the one or more of the low-temperature-side heat pipe,
wherein the high-temperature-side heat pipe and the low-temperature-side heat pipe are in thermal contact via the heat conduction member.

3. The heat transport device according to claim 1, wherein the heat conduction member connects a condensation section of the high-temperature-side heat pipe and a condensation section of the low-temperature-side heat pipe.

4. The heat transport device according to claim 1, wherein the liquid is an alcohol, a ketone, an ether or a glycol.

5. The heat transport device according to claim 1, wherein the liquid is a C6 or lower alcohol, a C6 or lower ketone, a C6 or lower ether, or a C6 or lower glycol.

6. The heat transport device according to claim 1, wherein the liquid is acetone.

7. The heat transport device according to any one of claims 1 to 6, wherein a concentration of the liquid contained in the low-temperature-side working fluid is 1 wt% or more and 40 wt% or less.
